# EUROPÄISCHE PATENTANMELDUNG

(11) **EP 0 720 238 A2**
(43) Veröffentlichungstag der Anmeldung: **03.07.1996**
(21) Anmeldenummer: 95114021.9
(22) Anmeldetag: 07.09.1995
(51) Int. Cl.: H01L 29/94, H01L 27/08

(54) **Schaltungsanordnung zur Verminderung der Spannungsabhängigkeit einer MOS-Kapazität**

(30) Priorität: 31.12.1994 DE 4447307
(71) Anmelder: ROBERT BOSCH GMBH, 70442 Stuttgart (DE)
(72) Erfinder: Kainer, Robert, Dr.-Ing., D-72770 Reutlingen (DE)

(57) **Zusammenfassung**

Die Erfindung betrifft eine Schaltungsanordnung zur Verminderung der Spannungsabhängigkeit einer MOS-Kapazität, die von einem Gate-Anschluß, einem Gateoxid und einem Substrat eines MOS-Transistors gebildet wird.

Es ist vorgesehen, daß wenigstens zwei MOS-Transistoren (10) in Reihe geschaltet sind und die miteinander verbundenen Anschlüsse (54, 56) der MOS-Transistoren (10) kurzzeitig auf ein gemeinsames Anfangspotential (U₀) gelegt sind, das so groß gewählt ist, daß die MOS-Kapazitäten (34) im wesentlichen ausschließlich von dem Gateoxid (32) bestimmt werden.

## Beschreibung

Die Erfindung betrifft eine Schaltungsanordnung zur Verminderung der Spannungsabhängigkeit einer MOS-Kapazität nach dem Oberbegriff des Anspruchs 1.

### Stand der Technik

Es ist bekannt, in MOS-Schaltungen (Metalloxid-Semiconductor-Schaltungen) MOS-Kapazitäten mittels MOS-Transistoren darzustellen. Die Kapazitäten werden hierbei von einem Gate-Anschluß, einem Gateoxid und einem Substrat, beispielsweise einem Siliziumsubstrat, der MOS-Schaltung gebildet. Die von einem MOS-Transistor gebildete MOS-Kapazität hat gegenüber der von einer Schichtfolge eines ersten Polysiliziums eines Oxids und eines zweiten Polysiliziums beziehungsweise eines Polysiliziums, eines Oxids und eines Metallkontaktes oder eines ersten Metallkontaktes eines Oxids und eines zweiten Metallkontaktes gebildeten MOS-Kapazität den Vorteil, daß ein geringerer Flächenbedarf auf einer MOS-Schaltung benötigt wird. Jedoch besteht der Nachteil, daß die von einem MOS-Transistor gebildete MOS-Kapazität eine große Spannungsabhängigkeit aufweist, das heißt, die MOS-Kapazität in Anhängigkeit einer Betriebsspannungsänderung großen Schwankungen unterliegt. Ein Einsatz der von MOS-Transistoren gebildeten MOS-Kapazitäten ist daher nur beschränkt möglich, so daß der Vorteil der Flächeneinsparung aufgrund der Spannungsabhängigkeit nicht genutzt werden kann.

### Vorteile der Erfindung

Die erfindungsgemäße Schaltungsanordnung mit den im Anspruch 1 genannten Merkmalen bietet demgegenüber den Vorteil, daß mit einem äußerst geringen Flächenbedarf bei MOS-Schaltungen eine im wesentlichen spannungsunabhängige MOS-Kapazität dargestellt werden kann. Dadurch, daß wenigstens zwei MOS-Transistoren in Reihe geschaltet sind und die miteinander verbundenen Anschlüsse der MOS-Transistoren kurzzeitig auf ein gemeinsames Anfangspotential gelegt sind, das so groß gewählt ist, daß die Kapazitäten der jeweils in Reihe geschalteten MOS-Kapazitäten im wesentlichen ausschließlich von dem Gateoxid bestimmt werden, wird es möglich, den Betriebsspannungsbereich der MOS-Kapazitäten jederzeit in eine Region zu verschieben, in der der Kapazitätswert der MOS-Kapazitäten nicht mehr von der Spannung abhängt. Hierdurch wird es möglich, die Schaltungsanordnung in allen integrierten Schaltungen als MOS-Kapazität einzusetzen, wobei gegenüber den bisher einsetzbaren MOS-Kapazitäten eine erhebliche Flächeneinsparung eintritt. Gegenüber den üblicherweise eingesetzten MOS-Kapazitäten aus zwei Metallkontakten und einem dazwischen liegenden Oxidbereich ergibt sich eine Einsparung um einen Flächenfaktor von ca. 50. Insgesamt lassen sich somit integrierte Schaltungen, die MOS-Transistoren enthalten, sehr viel kostengünstiger produzieren. Insbesondere lassen sich somit auch Analogschaltungen preisgünstig zusammen mit Digitalschaltungen in integrierten Schaltungen auf einem Chip in einem Digitalprozeß herstellen.

Weitere vorteilhafte Ausgestaltungen der Erfindung ergeben sich aus den in den Unteransprüchen genannten Merkmalen.

### Zeichnung

Die Erfindung wird nachfolgend in Ausführungsbeispielen anhand der zugehörigen Zeichnungen näher erläutert. Es zeigen:
- Figur 1: eine schematische Schnittdarstellung durch einen MOS-Transistor;
- Figur 2: den Verlauf einer Gatekapazität in Abhängigkeit einer Spannung;
- Figur 3: die erfindungsgemäße Schaltungsanordnung zur Verminderung einer Spannungsabhängigkeit;
- Figur 4a bis 4d: Ersatzschaltbilder von vier Varianten eines MOS-Transistors;
- Figur 5a bis 5c: Ausführungsvarianten der erfindungsgemäßen Schaltungsanordnung;
- Figur 6: den Spannungsverlauf der in den Figuren 5 dargestellten erfindungsgemäßen Schaltungsanordnungen und
- Figur 7: die Restspannungsabhängigkeit der erfindungsgemäßen Schaltungsanordnung.

### Beschreibung der Ausführungsbeispiele

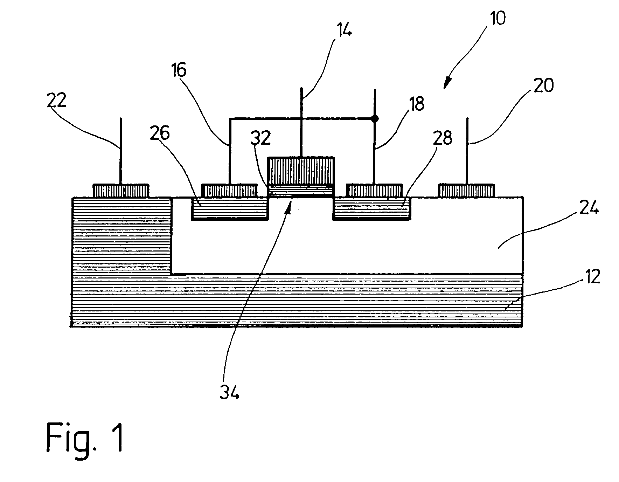

Figur 1 zeigt einen allgemein mit 10 bezeichneten MOS-Transistor in einer schematischen Darstellung. Der MOS-Transistor 10 ist in einem im Rahmen der Beschreibung nicht näher zu betrachtenden Herstellungsprozeß auf einem Substrat 12 realisiert. Der MOS-Transistor 10 besitzt einen Gate-Anschluß 14, einen Source-Anschluß 16 sowie einen Drain-Anschluß 18. Ferner besitzt der Transistor 10 einen Well-Anschluß 20 und einen Bulk-Anschluß 22. Das Substrat 12 kann beispielsweise ein p⁻-Substrat sein, in dem ein mit dem Well-Anschluß 20 kontaktierter n⁻-Bereich 24 vorgesehen ist. Innerhalb des n⁻-Bereiches 24 ist ein erster p⁻-Bereich 26 und ein zweiter p⁻-Bereich 28 vorgesehen. Zwischen dem n⁻-Bereich 24 und dem Gate-Anschluß 14 ist ein Gateoxid 32 vorgesehen. Der in Figur 1 gezeigte MOS-Transistor 10 ist somit ein p-Kanal-MOS-Transistor, der beispielsweise in einem sogenannten n⁻-well-CMOS-Prozeß hergestellt wurde. Die Darstellung in Figur 1 ist lediglich beispielhaft, um den grundsätzlichen Aufbau eines MOS-Transistors zu verdeutlichen. Anstelle des p-Kanal-MOS-Transistors kann selbstverständlich auch ein n-Kanal-MOS-Transistor mit entsprechend anders dotierten Bereichen 24, 26 und 28 und anders dotiertem Substrat 12 Verwendung finden. Durch den Aufbau des MOS-Transistors 10 ergibt sich zwischen dem Gate-Anschluß 14 und dem n⁻-Bereich 24 des Substrats 12 eine MOS-Kapazität 34, die als Dielektrikum das Gateoxid 32 aufweist.

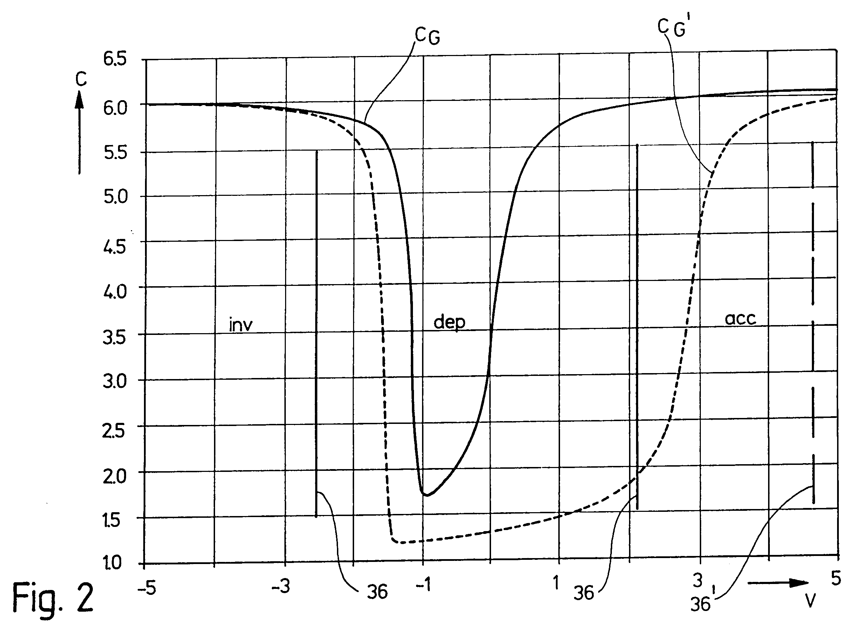

In der Figur 2 wird das spannungsabhängige Verhalten der Kapazität C der MOS-Kapazität 34 von einer Betriebsspannung U verdeutlicht. Nach einem ersten Beispiel - in Figur 2 mit der durchgezogenen Linie dargestellt - sind der Source-Anschluß 16, der Drain-Anschluß 18 und der Well-Anschluß 20 miteinander verbunden. Die miteinander verbundenen Anschlüsse 16, 18 und 20 sind hierbei an ein Potential von 0 V gelegt, während der Bulk-Anschluß 22 beispielsweise an ein Potential von -2,5 V liegt. Der Gate-Anschluß 14 ist mit einem variablen Spannungspotential beaufschlagbar, wobei im gezeigten Beispiel die Betriebsspannung U einen Wertebereich von -5 V bis +5 V durchfährt.

Anhand des in Figur 2 gezeigten Kurvenverlaufes wird deutlich, daß die Gate-Kapazität C_{G} der in Figur 1 mit 34 bezeichneten MOS-Kapazität in Abhängigkeit der anliegenden Betriebsspannung U starken Schwankungen unterliegt. Für den Bereich von hohen positiven Betriebsspannungen U zwischen dem Gate-Anschluß 14 und den an 0 V gelegten, zusammengeschalteten Anschlüssen 16, 18 und 20 sammeln sich an dem Gateoxid 32 auf seiten des Gate-Anschlusses 14 positive Ladungsträger, während an die dem Substrat 12 zugewandte Seite des Gateoxids 32 von dem n⁻-Bereich 24 als negativem Pol Elektronen geliefert werden. Der MOS-Transistor 10 ist in diesem Fall total gesperrt, so daß die MOS-Kapazität 34 ausschließlich durch die Dicke des Gateoxids 32 als Dielektrikum gebildet wird. Der MOS-Transistor 10 stellt somit eine reine MOS-Kapazität dar. Wird die Betriebsspannung U nunmehr gegen Werte um 0 V gefahren, also verkleinert, verarmt der n⁻-Bereich 24 unter dem Gateoxid 32 an beweglichen Ladungsträgern. Hierdurch bildet sich unter dem Gateoxid 32 eine Sperrschicht aus, da die beweglichen negativen Elektronen durch die negativ werdende Ladung an der dem Gate-Anschluß 14 zugewandten Seite des Gateoxids 32 abgestoßen, das heißt zurückgedrängt werden. Diese von dem Verarmungsbereich der negativen Ladungsträger gebildete Sperrschicht wirkt wie ein in Reihe zu dem von dem Gateoxid 32 gebildeten MOS-Kapazität 34 geschalteter Kondensator, so daß aufgrund der Reihenschaltung der Kapazitäten die Gesamtkapazität kleiner wird. Anhand des in Figur 2 gezeigten Verlaufs der Gatekapazität C_{G} wird deutlich, daß mit Kleinerwerden der Betriebsspannung U, etwa ab dem Bereich von 2 V, der Wert der Gatekapazität C_{G} bis zu einem Betriebsspannungswert von ca. -1 V abfällt. Nachdem die Betriebsspannung U eine Schwellspannung des MOS-Transistors 10 unterschreitet, bildet sich unterhalb des Gateoxids 32 eine Inversionsschicht aus, die durch Minoritätsladungsträger, also positiven Ladungsträgern aus dem p⁺-Bereich 26 beziehungsweise 28 als leitende p-Schicht aufrechterhalten wird. Dieser sich einstellende p-Kanal bewirkt in bekannter Weise die Schaltfunktion des MOS-Transistors 10. Durch diesen sich ausbildenden p-Kanal unterhalb des Gateoxids 32 steigt die Gatekapazität C_{G} wieder auf Werte an, die durch die Dicke des als Dielektrikum wirkenden Gateoxids 32 bestimmt wird.

Die Gatekapazität C_{G} fällt mit sinkender Betriebsspannung U, also von einem maximalen Wert auf einen minimalen Wert ab, von dem sie nach Überschreiten der Schwellspannung für den MOS-Transistor 10 wieder auf den maximalen Wert ansteigt. Die Gatekapazität C_{G} durchfährt somit drei Wertebereiche, die in der Figur 2 durch die senkrecht verlaufenden, hier mit 36 bezeichneten Grenzen verdeutlicht werden. Ein erster Wertebereich für hohe Betriebsspannungen U, in denen die Gatekapazität C_{G} nahezu konstant ist, wird mit acc (Akkumulation an Majoritätsladungsträgern) bezeichnet. Der sich anschließende, bei sinkender Betriebsspannung U sich ergebende Wertebereich, in dem die Gatekapazität C_{G} auf den Minimalwert absinkt und von diesem wieder auf den Maximalwert ansteigt, wird mit dep (Depletion) bezeichnet. Der dritte Wertebereich der Gatekapazität C_{G} bei hohen negativen Betriebsspannungen U wird mit inv (Inversion) bezeichnet.

Anhand des in Figur 2 mit einer gestrichelten Linie dargestellten Gatekapazitätsverlaufs C_{G}' wird die Spannungsabhängigkeit der Gatekapazität C_{G} gemäß einer anderen Verschaltung des in Figur gezeigten MOS-Transistors 10 verdeutlicht. Bei dieser Verschaltungsvariante sind wiederum der Source-Anschluß 16 und der Drain-Anschluß 18 miteinander verbunden, während der Well-Anschluß 20 an einem positiven Potential, beispielsweise von 2,5 V gelegt ist. Bei dieser Variante wird der dep-Bereich der MOS-Kapazität 34 verbreitert, das heißt, über einen größeren Bereich der Betriebsspannung U ergibt sich eine Variation der Gatekapazität C_{G}'. Die Verbreiterung des dep-Bereiches ist durch die mit 36' bezeichnete Grenze verdeutlicht.

Anhand der Figuren 1 und 2 wird also deutlich, daß bei gemäß dem Stand der Technik gebildeten MOS-Kapazitäten 34 eine erhebliche Abhängigkeit der Gatekapazität C_{G} von einer Betriebsspannung U gegeben ist.

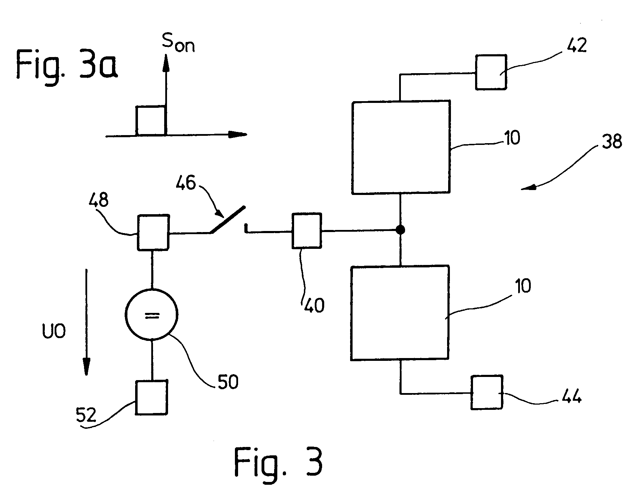

In der Figur 3 ist eine Schaltungsanordnung 38 gezeigt, mittels der sich die Abhängigkeit der Gatekapazität C_{G} von der Betriebsspannung U verhindern beziehungsweise zumindest drastisch vermindern läßt. Die Schaltungsanordnung 38 besteht aus einer Reihenschaltung von zwei MOS-Transistoren 10, wobei deren zusammengeschalteten Anschlüsse mit einer Anschlußklemme 40 verbunden sind. Die Reihenschaltung der zwei MOS-Transistoren 10 besitzt weiterhin eine erste äußere Anschlußklemme 42 und eine zweite äußere Anschlußklemme 44. Die Anschlußklemme 40 ist mit einem Schaltelement 46 verbunden, an dessen der Anschlußklemme 40 abgewandten Anschluß 48 eine Spannung U₀ liegt. Die Spannung U₀ kann durch eine Spannungsquelle 50 bereitgestellt werden, die zwischen der Anschlußklemme 48 des Schalters 46 und einem Ground-Potential 52 liegt. Die Schaltungsanordnung 38 ist so ausgelegt, daß der Schalter 46 gemäß dem Schaltsignalverlauf S über der Zeit, wie Figur 3a zeigt, die Anschlußklemme 40 der Reihenschaltung der zwei MOS-Transistoren 10 mit dem Anfangspotential U₀ verbindet. Der Schalter 46 ist hierbei nur kurzzeitig geschlossen und öffnet wieder, nachdem die aus den MOS-Transistoren 10 bestehende Reihenschaltung ihren bestimmungsgemäßen, innerhalb eines größeren - hier nicht dargestellten - Schaltungsverbundes ihren Funktionszustand eingenommen hat. Die Größe des Anfangspotentials U₀, das kurzzeitig an die Anschlußklemme 40 gelegt wird, ist so groß, daß eine Potentialdifferenz zwischen den Anschlußklemmen 40 und 44 und den Anschlußklemmen 40 und 42 für sämtliche Potentiale, die während des bestimmungsgemäßen Gebrauchs der Schaltungsanordnung 38 an den Anschlußklemmen 42 und 44 auftreten können, den Wert übersteigen, der den in Figur 2 verdeutlichten dep-Bereich von dem inv-Bereich beziehungsweise dem acc-Bereich trennt. Hiermit wird erreicht, daß der dep-Bereich, innerhalb dem die Gatekapazität C_{G} stark spannungsabhängig ist, eliminiert werden kann, so daß sich die Gatekapazitäten C_{G} der MOS-Transistoren 10 innerhalb der Schaltungsanordnung 38 als spannungsunabhängige MOS-Kondensatoren 34 verhalten.

Diese Spannungsunabhängkeit der Gatekapazität C_{G} gilt auch für den Fall, daß jeder der MOS-Transistoren 10 in der Schaltungsanordnung 38 aus einer Vielzahl parallel zueinander geschalteter MOS-Transistoren 10 besteht. Bei der Parallelschaltung einer Vielzahl von MOS-Transistoren 10 ist lediglich zu beachten, daß zur Bildung einer Gatekapazität C_{G} MOS-Transistoren gleichen Typs, wie noch näher erläutert wird, zur Bildung eines MOS-Transistors 10 gemäß der Schaltungsanordnung 38 zusammengeschaltet werden. In jedem Fall ist gewährleistet, daß die Gatekapazitäten C_{G} der MOS-Transistoren 10 beziehungsweise der Reihenschaltung der MOS-Transistoren 10 unabhängig davon, ob jeder MOS-Transistor 10 aus einem einzelnen oder einer Vielzahl parallel zueinander geschalteter MOS-Transistoren besteht, durch das kurzzeitige Verbinden der Anschlußklemme 40 mit dem Anfangspotential U₀ sich wie spannungsunabhängige Kondensatoren verhalten.

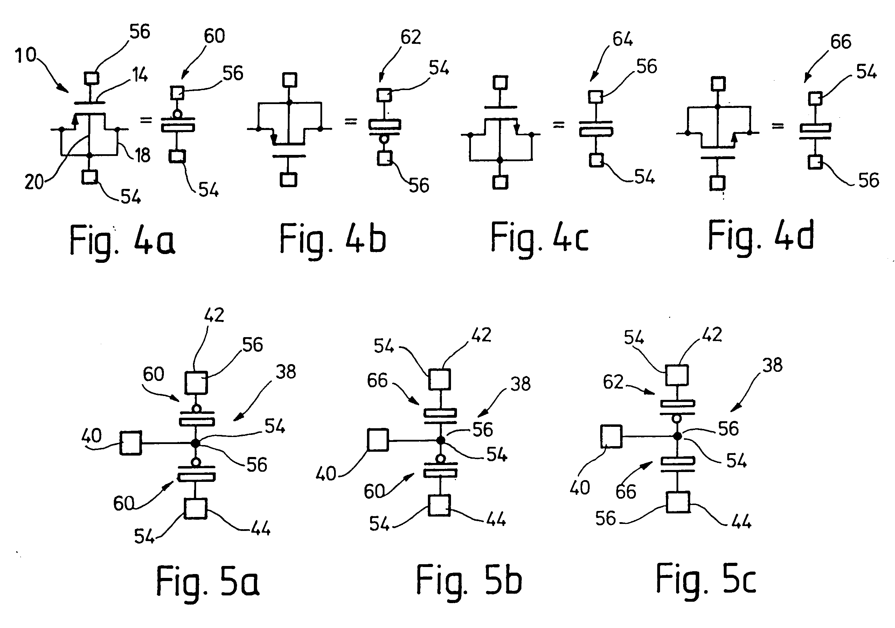

Nachfolgend sollen verschiedene Schaltungsvarianten der Schaltungsanordnung 38 näher erläutert werden. In den Figuren 4a bis 4d ist jeweils eine Grundvariante eines MOS-Transistors 10 mit einem Ersatzschaltbild und einem Symbolbild dargestellt. Bei den MOS-Transistoren 10 ist jeweils der Source-Anschluß 16 mit dem Drain-Anschluß 18 und dem Well-Anschluß 20 zusammengeschaltet. Diese zusammengeschalteten Anschlüsse ergeben einen Anschluß 54 des MOS-Transistors 10, während der Gate-Anschluß 14 hier als Anschluß 56 bezeichnet ist. In Figur 4a ist somit ein MOS-Transistor 10 in einem Ersatzschaltbild und einem Symbolbild dargestellt, wie er dem in Figur 1 erläuterten Beispiel entspricht. Der hier vorhandene P-Kanal-MOS-Transistor ist durch den Kreis auf dem Gate-Anschluß 14 symbolisiert. Figur 4a zeigt somit einen P-Kanal-MOS-Transistor 60 mit obenliegendem Gate-Anschluß 14. Figur 4b zeigt einen P-Kanal-MOS-Transistor 62 mit untenliegendem Gate-Anschluß 14. In der Figur 4c ist ein n-Kanal-MOS-Transistor mit obenliegendem Gate-Anschluß 14 gezeigt, während in Figur 4d ein n-Kanal-MOS-Transistor 66 mit untenliegendem Gate-Anschluß 14 dargestellt ist. Zur Vereinfachung wird im folgenden nur noch von Transistoren 60 bis 66 gesprochen, wobei klar ist, daß es sich hierbei um die in den Figuren 4a bis 4d dargestellten vier Grundvarianten eines MOS-Transistors 10 handelt. Die Bezeichnung oben und unten bezieht sich lediglich auf die bildliche Darstellung in den Figuren 4a bis 4d.

In den Figuren 5a bis 5c ist die Schaltungsanordnung 38 in drei Ausführungsvarianten gezeigt. Gemäß der in Figur 5a gezeigten Variante besteht die Schaltungsanordnung 38 aus einer Reihenschaltung zweier Transistoren 60. Hierbei sind die Transistoren 60 so geschaltet, daß der Anschluß 54 des oberen Transistors 60 mit dem Anschluß 56 des unteren Transistors 60 zusammen gemeinsam auf die Anschlußklemme 40 geschaltet sind. Der Anschluß 56 des oberen Transistors 60 bildet gleichzeitig die Anschlußklemme 42, während der Anschluß 54 des unteren Transistors 60 gleichzeitig die Anschlußklemme 44 der Schaltungsanordnung 38 bildet. Gemäß der in Figur 5b gezeigten Ausführungsvariante besteht die Schaltungsanordnung 38 aus einem Transistor 66 und einem Transistor 60. Die Anschlußklemme 42 wird hier von dem Anschluß 54 des Transistors 66 und die Anschlußklemme 44 von dem Anschluß 54 des Transistors 60 gebildet. Die Anschlußklemme 40 ergibt sich aus den zusammengeschalteten Anschlüssen 56 des Transistors 66 und des Transistors 60. In einem weiteren, in Figur 5c gezeigten Ausführungsbeispiel ergibt sich die Schaltungsanordnung 38 aus einer Reihenschaltung eines Transistors 62 und eines Transistors 66. Die Anschlußklemme 42 wird hier von dem Anschluß 54 des Transistors 62 gebildet und die Anschlußklemme 44 von dem Anschluß 56 des Transistors 66. Die Anschlußklemme 40 ergibt sich aus dem zusammengeschalteten Anschluß 56 des Transistors 62 und dem Anschluß 54 des Transistors 66. Die in den Figuren 5a bis 5c gezeigten Varianten der Schaltungsanordnung 38 sind lediglich beispielhaft. So kann die Schaltungsanordnung 38 aus einer Reihenschaltung jeder der in den Figuren 4a bis 4d gezeigten Transistoren 60, 62, 64 und 66 bestehen. Somit ergeben sich für die Schaltungsanordnung 38 insgesamt 16 verschiedene Schaltungskonfigurationen. Die Auswahl der verwendeten Transistoren ist lediglich von dem gesamten Herstellungsprozeß der integrierten Schaltung abhängig, so daß die Ausbildung der Schaltungsanordnung 38 in einfacher Weise variabel an diesen Herstellungsprozeß anpaßbar ist.

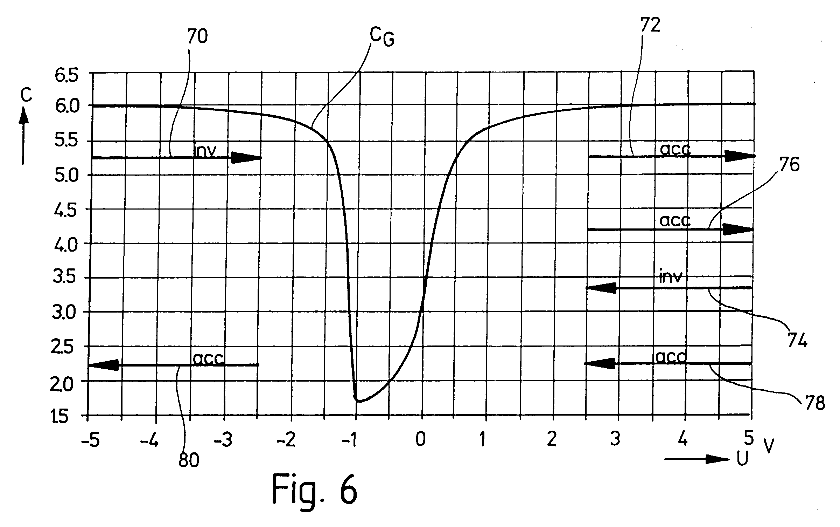

Anhand der Figur 6 wird das Verhalten der in Figur 5a bis 5c gezeigten Schaltungsanordnungen 38 verdeutlicht. In Figur 6 ist wiederum der Verlauf der Gatekapazität C_{G} über die Betriebsspannung U aufgetragen. Bei einem beispielhaften Einsatzfall, nach dem die Schaltungsanordnung 38 als Integrator-Kapazität zwischen einem Eingang und einem Ausgang eines Operationsverstärkers geschaltet ist, liegt beispielsweise die Anschlußklemme 44 auf einem Potential von 0 V, während die Anschlußklemme 42 als Ausgang von einem Spannungswert zwischen -2,5 V bis +2,5 V variieren kann. Bei den Ausführungsbeispielen wird davon ausgegangen, daß jeweils die Gateoxidfläche der beiden MOS-Kapazitäten 34 gleich groß ist, so daß sich die Variationsbreite von 5 V zwischen den Anschlußklemmen 42 und 44 in einer Variationsbreite von 2,5 V an der Anschlußklemme 40 niederschlägt. Für den Fall, daß die Gateoxidflächen der MOS-Kapazität 34 der an der Schaltungsanordnung 38 beteiligten MOS-Transistoren 10 unterschiedlich groß ist, ergibt sich eine entsprechend dem kapazitiven Teilerverhältnis angepaßte Spannungsvariation an der Anschlußklemme 40. Bei der Annahme, daß die Gateoxidflächen gleich groß sind, kann die Anfangsspannung U₀, die an die Anschlußklemme 40 gelegt wird, ca. +2,5 V betragen. Nach Öffnen des Schalters 46, das heißt nach Abschalten der Anfangsspannung U₀ floatet die Anschlußklemme 40, das heißt, die Spannung variiert im Bereich von + 2,5 V bis +5 V. Diese Spannungsvariation ergibt sich gleichzeitig zwischen der Anschlußklemme 40 und der Anschlußklemme 44. Zwischen der Anschlußklemme 42 und der Anschlußklemme 40 variiert die Spannung zwischen -5 V und -2,5 V.

Bei der in Figur 5a gezeigten Variante der Schaltungsanordnung 38 ist der obere Kondensator 60 stets im inv-Bereich und der untere Kondensator 60 stets im acc-Bereich. Diese Bereiche sind in der Figur 6 mit den Pfeilen 70 für den oberen Kondensator 60 und 72 für den unteren Kondensator 60 verdeutlicht.

Bei der in Figur 5b gezeigten Schaltungsanordnung 38 befindet sich der obere Kondensator 66 im inv-Bereich, da die Potentialdifferenz zwischen der Anschlußklemme 40 und der Anschlußklemme 42 von +5 V gegen +2,5 V geht. Der untere Kondensator 60 verbleibt im acc-Bereich. Das Kapazitätsverhalten der in Figur 5b geschalteten Kondensatoren 66 und 60 ist in Figur 6 mit den Pfeilen 74 und 76 verdeutlicht.

Schließlich liegen die gemäß der Schaltungsanordnung 38 in Figur 5c zusammengeschalteten Kondensatoren 62 und 66 jeweils stets im acc-Bereich. Dies ist mit den Pfeilen 78 und 80 in Figur 6 verdeutlicht.

Insgesamt wird also deutlich, daß die Gatekapazität C_{G} der zu der Reihenschaltung der Schaltungsanordnung 38 verschalteten Kondensatoren 60, 62, 64 oder 66 jeweils in Betriebs-Spannungsbereichen verschoben werden, in denen der Kapazitätswert, also in dem inv-Bereich oder dem acc-Bereich, nahezu nicht mehr von der Betriebsspannung U abhängig ist. Die Schaltungsanordnung 38 kann somit in allen integrierten Schaltungen als reiner Kondensator eingesetzt werden. Die Wahl, welche der Kondensatoren 60, 62, 64 oder 66 für die Schaltungsanordnung 38 verwendet werden, hängt in entscheidendem Maße von dem zur Verfügung stehenden Prozeß der Herstellung der integrierten Schaltungen, deren Bestandteil die Schaltungsanordnung 38 ist, ab. Günstigerweise wird man für einen p-well-CMOS-Prozeß eine der vier sich aus den Kondensatoren 64 und 66 ergebenden Kombinationen bevorzugen. Für einen n-well-CMOS-Prozeß hingegen wird eine der vier zur Verfügung stehenden Möglichkeiten aus den Transistoren 60 beziehungsweise 62 bevorzugt sein. Jedoch sind auch Mischtypen denkbar, wie diese beispielsweise in der Figur 5b und 5c dargestellt sind, wenn der Herstellungsprozeß der integrierten Schaltungen ein getrenntes Anlegen der well-Bereiche (Bereich 24 in Figur 1) als n-Bereich oder p-Bereich zuläßt.

Vorteilhaft kann vorgesehen sein, daß während des Betriebes der Schaltungsanordnung 38 der Schalter 46 getaktet ist, das heißt, die Anfangsspannung U₀ in regelmäßigen Abständen an die Anschlußklemme 40 gelegt wird. Hierdurch wird einer Verschiebung der Betriebs-Spannungsbereiche der MOS-Kapazitäten 34 innerhalb der Schaltungsanordnung 38 in Richtung der dep-Bereiche entgegengewirkt, die zu einer Schwankung der Gatekapazität C_{G} führen würde. Diese Verschiebung kann sich aufgrund von Leckströmen einstellen, die zu einer Reduzierung der durch das Anlegen der Anfangsspannung U₀ an die Anschlußklemme 40 gebrachten Ladung führt.

Die Schaltungsanordnung 38 kann als getaktete Kapazität eingesetzt werden, das heißt, durch Kurzschließen der Anschlußklemme 42 und 44 beziehungsweise deren Verbinden mit dem Ground-Potential 52 und anschließendem kurzzeitigen Betätigen des Schalters 46, so daß die Anschlußklemme 40 wieder auf das Anfangspotential U₀ gelegt wird.

Beim Einsatz der Schaltungsanordnung 38 als Integrator-Kapazität kann eine Hilfsschaltung verwendet werden, in der die in der Schaltungsanordnung 38 angesammelte Ladung auf eine andere Schaltungsanordnung 38, die ebenfalls eine spannungsunabhängige MOS-Kapazität darstellt, übertragen wird. Die als Integrator-Kapazität verwendete Schaltungsanordnung 38 wird dann durch kurzzeitiges Anlegen der Anfangsspannung U₀ reinitialisiert, und die zuvor übertragene Ladung auf die als Hilfsschaltung dienende Schaltungsanordnung 38 wird anschließend zurückübertragen.

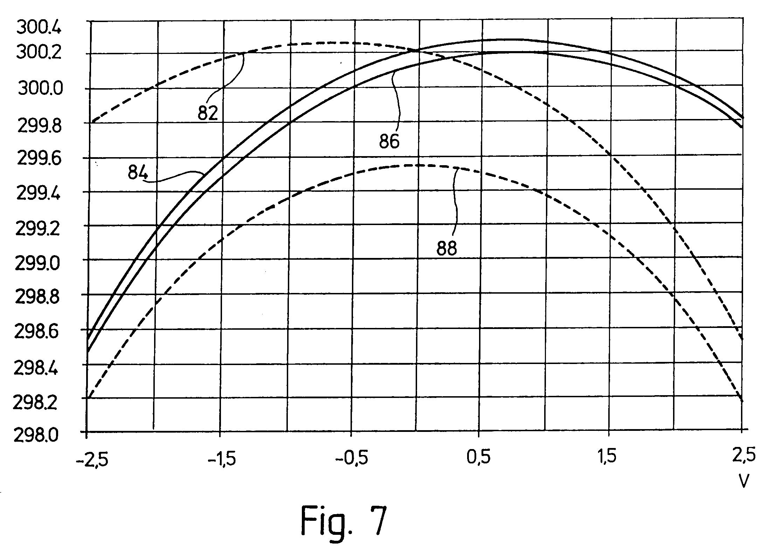

In der Figur 7 ist beispielhaft die Restspannungsabhängigkeit der Schaltungsanordnung 38 für eine Reihenschaltung verschiedener Transistoren 60, 62, 64 oder 66 dargestellt. Die mit 82 bezeichnete Linie stellt die Restspannungsabhängigkeit einer Schaltungsanordnung 38 aus der Reihenschaltung von zwei Transistoren 60 gemäß Figur 5a dar. Weiterhin ist die Restspannungsabhängigkeit einer Reihenschaltung zweier Transistoren 62 mit der Linie 84 dargestellt. Mit der Linie 86 ist die Reihenschaltung eines Transistors 62 mit einem Transistor 66 zu der Schaltungsanordnung 38 dargestellt, während die Linie 88 die Restspannungsabhängigkeit einer Reihenschaltung eines Transistors 64 und eines Transistors 66 zu der Schaltungsanordnung 38 verdeutlicht. Insgesamt wird anhand dieser beispielhaft aufgetragenen vier der insgesamt 16 Varianten deutlich, daß gegenüber dem in Figur 2 dargestellten Verlauf der Gatekapazität C_{G} eines einzelnen Transistors anstelle des Einbruchs des Kapazitätswertes C_{G} von 6 pF auf 1,7 pF (entspricht -71,7 %) jetzt lediglich nur noch eine Variation von einem Minimalwert zu einem Maximalwert von 13,5 fF bis 17,3 fF bei einem angenommenen Nennwert von ca. 3 pF auftritt. Die Variation beträgt somit also lediglich nur noch 0,45 % bis 0,58 %. Die Restspannungsabhängigkeit ist somit für eine Vielzahl der Anwendungsmöglichkeiten von MOS-Kapazitäten vernachlässigbar klein.

## Patentansprüche

1. Schaltungsanordnung zur Verminderung der Spannungsabhängigkeit einer MOS-Kapazität, die von einem Gate-Anschluß, einem Gateoxid und einem Substrat eines MOS-Transistors gebildet wird, **dadurch gekennzeichnet**, daß wenigstens zwei MOS-Transistoren (10) in Reihe geschaltet sind und die miteinander verbundenen Anschlüsse (54, 56) der MOS-Transistoren (10) kurzzeitig auf ein gemeinsames Anfangspotential (U₀) gelegt sind, das so groß gewählt ist, daß die MOS-Kapazitäten (34) im wesentlichen ausschließlich von dem Gateoxid (32) bestimmt werden.

2. Schaltungsanordnung nach Anspruch 1, **dadurch gekennzeichnet**, daß jeder der in Reihe geschalteten MOS-Transistoren (10) von einer Parallelschaltung von MOS-Einzeltransistoren des gleichen Typs gebildet wird.

3. Schaltungsanordnung nach einem der vorhergehenden Ansprüche, **dadurch gekennzeichnet**, daß die Reihenschaltung von einem p-MOS-Transistor (60, 62) und einem n-MOS-Transistor (64, 66) gebildet wird.

4. Schaltungsanordnung nach einem der Ansprüche 1 bis 2, **dadurch gekennzeichnet**, daß die Reihenschaltung von zwei p-MOS-Transistoren (60, 62) gebildet wird.

5. Schaltungsanordnung nach einem der Ansprüche 1 bis 2, **dadurch gekennzeichnet**, daß die Reihenschaltung von zwei n-MOS-Transistoren (64, 66) gebildet wird.

6. Schaltungsanordnung nach einem der vorhergehenden Ansprüche, **dadurch gekennzeichnet**, daß jeweils der Gate-Anschluß (14) der MOS-Transistoren (10, 60, 62, 64, 66) an das gemeinsame Anfangspotential U₀ gelegt ist.

7. Schaltungsanordnung nach einem der vorhergehenden Ansprüche, **dadurch gekennzeichnet**, daß jeweils der zusammengeschaltete Source-Anschluß (16), Drain-Anschluß (18) und Well-Anschluß (20) der in Reihe geschalteten MOS-Transistoren (10, 60, 62, 64, 66) an das gemeinsame Anfangspotential U₀ gelegt sind.

8. Schaltungsanordnung nach einem der vorhergehenden Ansprüche, **dadurch gekennzeichnet**, daß ein Gate-Anschluß (14) des einen MOS-Transistors (10, 60, 62, 64, 66) und ein zusammengeschalteter Source-Anschluß (16), Drain-Anschluß (18) und Well-Anschluß (20) des anderen MOS-Transistors (10, 60, 62, 64, 66) an das gemeinsame Anfangspotential U₀ gelegt sind.

9. Schaltungsanordnung nach einem der vorhergehenden Ansprüche, **dadurch gekennzeichnet**, daß an den miteinander verbundenen Anschlüssen (54, 56) der MOS-Transistoren (10, 60, 62, 64, 66) nach Abschalten des Anfangspotentials U₀ eine Spannungsvariation einstellbar ist.

10. Schaltungsanordnung nach Anspruch 9, **dadurch gekennzeichnet**, daß die Spannungsvariation durch eine Dimensionierung der Gateoxide (32) der MOS-Transistoren (10, 60, 62, 64, 66) einstellbar ist.
